# EUROPEAN PATENT APPLICATION

(11) **EP 4 760 110 A2**
(43) Date of publication of application: **17.06.2026**
(21) Application number: 25219951.8
(22) Date of filing: 02.12.2025
(51) Int. Cl.: F04D 19/00, F04D 25/06, F04D 29/60, F04D 25/16, G06F 1/20, H05K 7/20

(54) **HEAT DISSIPATION DEVICE**

(30) Priority: 10.12.2024 CN 202423051134 U; 26.08.2025 CN 202511204508
(71) Applicant: Dongguan Chenjing Electronic Technology Co., Ltd., Dongguan City, Guangdong Province (CN)
(72) Inventor: LIN, Zhenhua, Dongguan City (CN); LI, Na, Dongguan City (CN); LIN, Jiaqi, Dongguan City (CN)
(74) Representative: Becker, Eberhard

(57) **Abstract**

Disclosed is a heat dissipation device (100, 100a, 100b) including a housing frame (3), a support member (2), and at least one fan (1). The support member (2) is secured on the housing frame (3) and includes a conductive circuit (22) and at least one conductive area (212) electrically connected to the conductive circuit (22). Each fan (1) includes a securing structure (15), a hub (101) that rotates relative to the securing structure (15), and a plurality of blades (11) extending from the hub (101). The securing structure (15) of each fan (1) is secured on the support member (2), and the securing structure (15) includes a conductive portion (131) that makes conductive contact with the corresponding conductive area (212). The heat dissipation device (100, 100a, 100b) of the present disclosure has a relatively simple structure that allows for easy assembly or replacement of a fan.

## Description

### BACKGROUND

### Technical Field

The present disclosure relates to a heat dissipation device, and particularly relates to a heat dissipation device that allows for convenient assembly or replacement of a fan.

### Description of Related Art

With the continuous enhancement in the performance of electronic devices, there are also increased power consumption and heat generated by the internal hardware of electronic devices. Particularly in the sectors of computers, servers, smartphones, automotive electronics, and industrial equipment, electronic components generate substantial amounts of heat during operation. If the heat cannot be dissipated promptly and effectively, it is possible to cause a decline in device performance, hardware damage, or even pose safety hazards. Therefore, heat dissipation has become a critical element in ensuring the stable operation of electronic devices. The primary function of fans for heat dissipaters is to accelerate the dissipation of heat through forced convection.

How to simplify the structure to enable fans to be easily assembled or replaced is an issue to be explored by practitioners in the field.

### SUMMARY

The present disclosure is directed to a heat dissipation device having a relatively simple structure that allows for easy assembly or replacement of a fan.

According to an embodiment of the present disclosure, a heat dissipation device includes a housing frame, a support member, and at least one fan. The support member is secured on the housing frame and includes a conductive circuit and at least one conductive area electrically connected to the conductive circuit. Each fan includes a securing structure, a hub that rotates relative to the securing structure, and a plurality of blades extending from the hub. The securing structure of each fan is secured on the support member. The securing structure includes a conductive portion that makes conductive contact with a corresponding conductive area.

In the heat dissipation device according to an embodiment of the present disclosure, the securing structure of each fan includes a locking portion. The support member includes an engaging slot that correspondingly engages with the locking portion.

In the heat dissipation device according to an embodiment of the present disclosure, the locking portion includes at least two elastic engaging arms distributed in a symmetrical manner. Each elastic engaging arm includes a protrusion located at an end portion, and the protrusion passes through the engaging slot and reversely engages with the support member.

In the heat dissipation device according to an embodiment of the present disclosure, the securing structure of each fan includes a screw set. The support member includes a hole corresponding to the screw set. Each fan is secured on the support member by a fastener, which passes through the hole and is secured on the screw set.

In the heat dissipation device according to an embodiment of the present disclosure, the support member includes at least one perforated hole corresponding to the at least one fan and passing through the support member.

In the heat dissipation device according to an embodiment of the present disclosure, the support member includes a first surface away from the fan and a second surface close to the fan. Each perforated hole has a dimension at the first surface greater than or equal to a dimension at the second surface.

In the heat dissipation device according to an embodiment of the present disclosure, the at least one fan includes a plurality of fans. The at least one conductive area includes a plurality of conductive areas. The housing frame includes a plurality of setting areas for accommodating the fans. The support member continuously passes through the plurality of setting areas, and the conductive areas respectively correspond to the setting areas.

In the heat dissipation device according to an embodiment of the present disclosure, the housing frame includes a plurality of mounting studs located at the periphery of the setting areas. The support member includes a plurality of mounting holes corresponding to the mounting studs. The support member is secured on the housing frame by a plurality of screws, which pass through the mounting holes and are secured on the mounting studs.

In the heat dissipation device according to an embodiment of the present disclosure, the housing frame includes a plurality of sets of positioning columns corresponding to the mounting studs. Each of the plurality of sets of positioning columns includes a first positioning column and a second positioning column disposed on opposite sides of the corresponding mounting stud. The support member includes a plurality of mounting fixing blocks extending along a direction perpendicular to an extending direction of the support member. Both ends of each of the mounting fixing blocks include a first positioning hole and a second positioning hole respectively corresponding to the first positioning column and the second positioning column.

In the heat dissipation device according to an embodiment of the present disclosure, the securing structure of each fan includes a connection plate and a driver. The driver is located in an accommodation chamber of the hub. The connection plate covers the accommodation chamber. The securing structure of each fan is connected to the support member through the connection plate. The conductive portion is located on the driver. The connection plate includes a docking hole for the conductive portion to pass through, and the conductive portion passes through the docking hole to contact the corresponding conductive area.

In the heat dissipation device according to an embodiment of the present disclosure, the connection plate includes a first bump and a second bump, and the support member is disposed between the first bump and the second bump to be limited.

In the heat dissipation device according to an embodiment of the present disclosure, the support member includes a circuit board, or the support member includes an insulation board and a circuit, a cable, or a flexible circuit board disposed on the insulation board.

In the heat dissipation device according to an embodiment of the present disclosure, the support member includes at least one mounting portion, a plurality of mounting fixing blocks, and a plurality of connection portions disposed between the at least one mounting portion and the mounting fixing blocks. Each mounting portion corresponds to the securing structure of the fan. The at least one conductive area is located at the at least one mounting portion. The mounting fixing blocks are secured on the housing frame. Each of the connection portions includes the perforated hole.

In the heat dissipation device according to an embodiment of the present disclosure, the height of the blades is greater than 9 millimeters.

In the heat dissipation device according to an embodiment of the present disclosure, the housing frame includes a single cable management structure configured to secure the conductive circuit.

The fan of the heat dissipation device of the present disclosure is secured on the support member through the securing structure, and the support member is secured on the housing frame, which is simple in structure. In addition, the heat dissipation device of the present disclosure utilizes the conductive contact between the conductive portion of the fan and the conductive area of the support member to achieve power supply to the fan. The mounting structure facilitates a simpler and more convenient assembly and disassembly of the fan, eliminating the need for additional cable connections. This convenience significantly enhances production efficiency, especially when utilizing multiple fans. The absence of cable connections allows for quicker assembly and disassembly of any single fan, thus meeting the requirement for all users to replace the fan independently.

### BRIEF DESCRIPTION OF THE DRAWINGS

FIG. 1 is a schematic view of a heat dissipation device according to an embodiment of the present disclosure.
FIG. 2 is a schematic view of another perspective of FIG. 1 with one of the fans not yet been disposed.
FIG. 3 is an exploded view of FIG. 1.
FIG. 4 is a partial enlarged view of an area A of FIG. 1.
FIG. 5 is an exploded view of the fan of FIG. 1.
FIG. 6 is a cross-sectional view of FIG. 1.
FIG. 7 and FIG. 8 are schematic views of different perspectives of a heat dissipation device according to another embodiment of the present disclosure.
FIG. 9 and FIG. 10 are exploded schematic views of FIG. 7 and FIG. 8.
FIG. 11 is a cross-sectional view taken along line B-B of FIG. 9.
FIG. 12 is a schematic view of different perspectives of a heat dissipation device according to another embodiment of the present disclosure.

### DESCRIPTION OF THE EMBODIMENTS

Reference will now be made in detail to exemplary embodiments of the present disclosure, examples of the exemplary embodiments are illustrated in the accompanying drawings. Wherever possible, the same reference numerals are used throughout the drawings and the description to refer to the same or like parts.

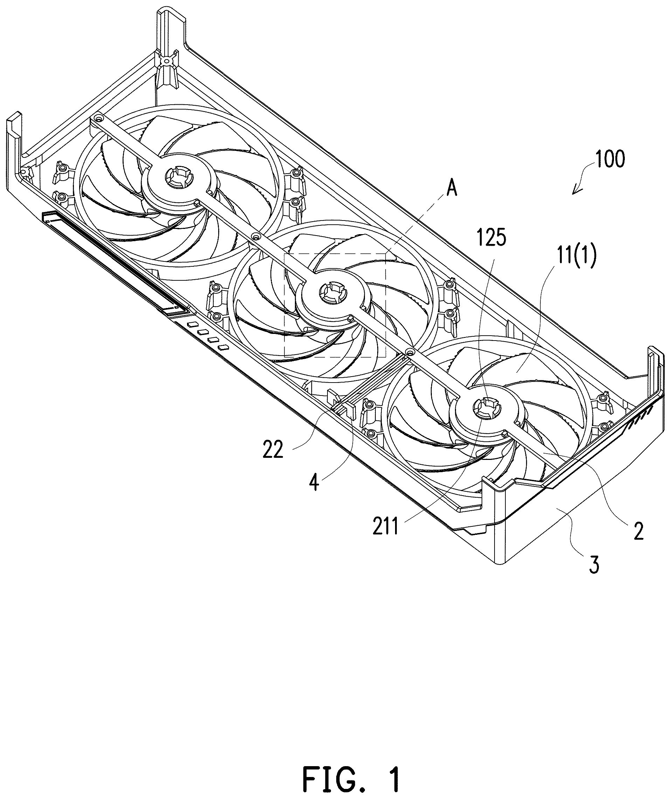

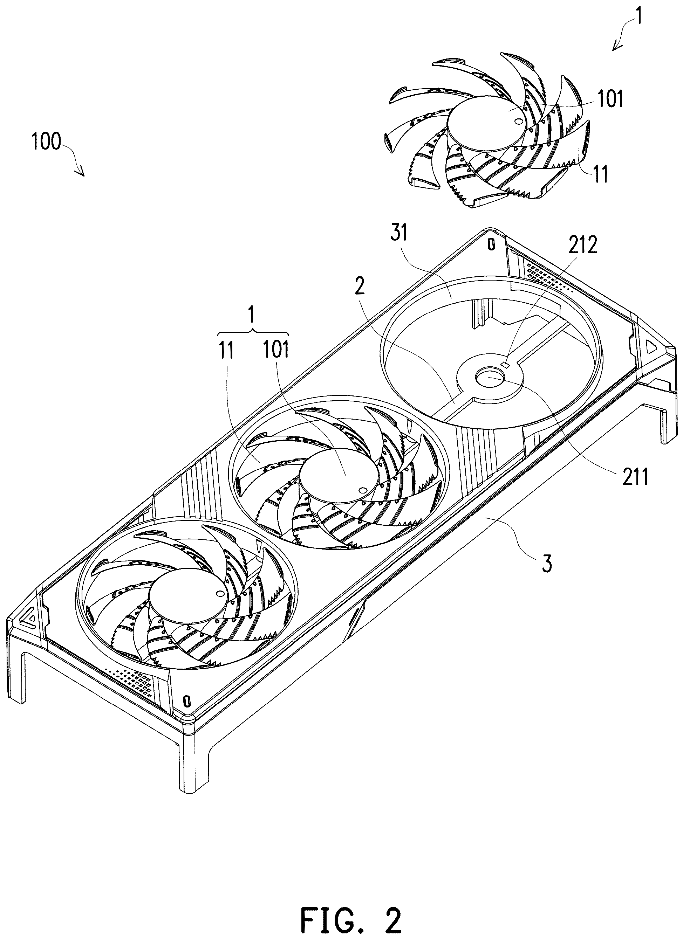

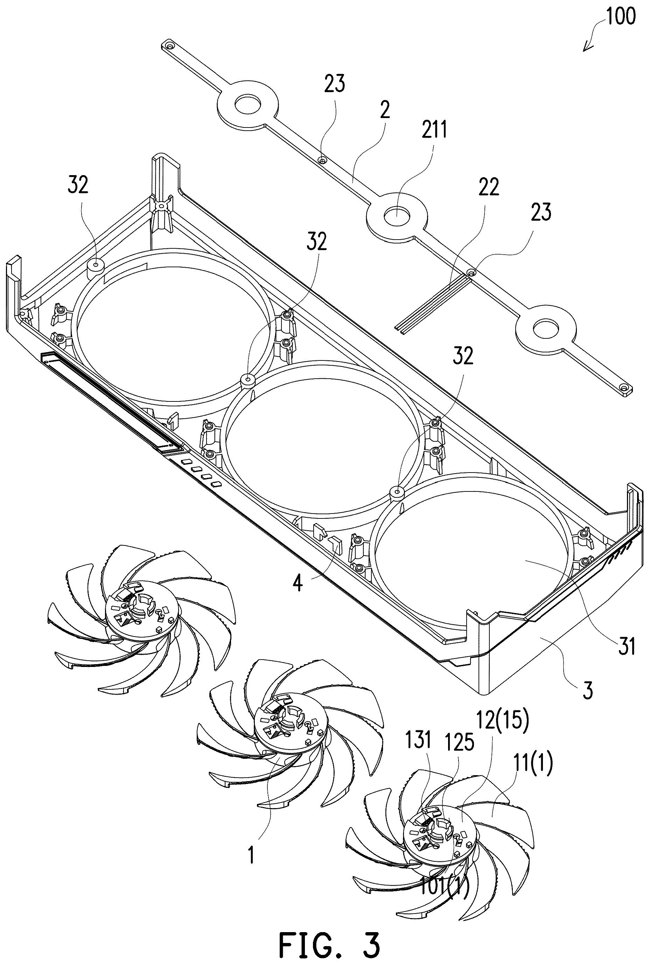

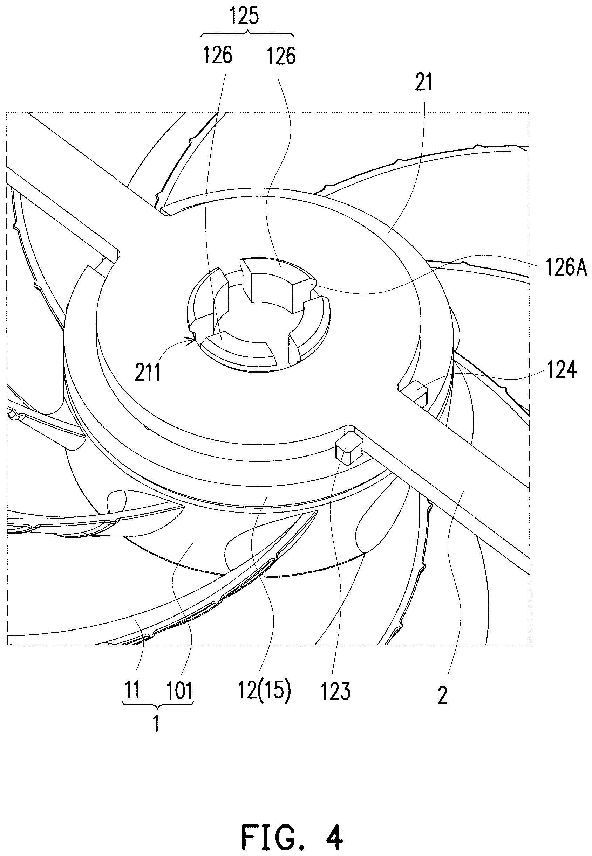

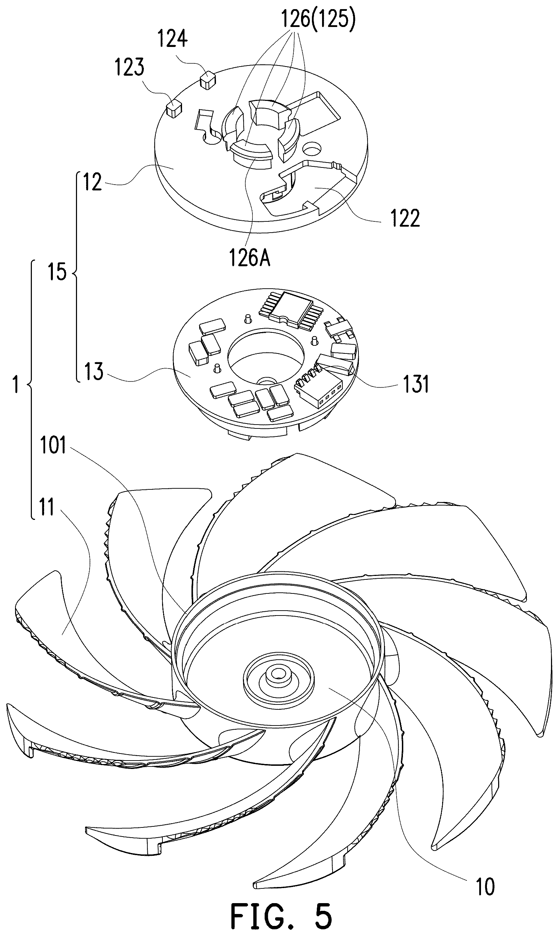

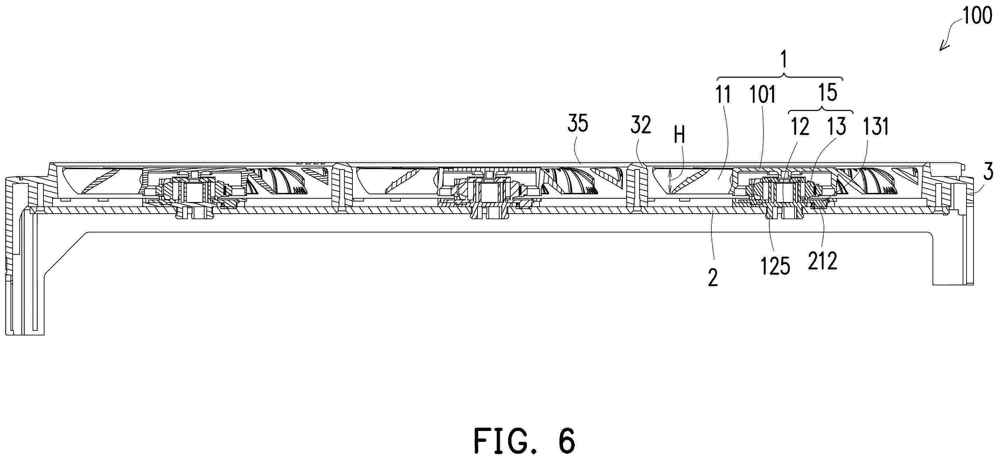

FIG. 1 is a schematic view of a heat dissipation device according to an embodiment of the present disclosure. FIG. 2 is a schematic view of another perspective of FIG. 1 with one of the fans not yet been disposed. FIG. 3 is an exploded view of FIG. 1. FIG. 4 is a partial enlarged view of an area A of FIG. 1. FIG. 5 is an exploded view of the fan of FIG. 1. FIG. 6 is a cross-sectional view of FIG. 1.

Please refer to FIG. 1 to FIG. 6, a heat dissipation device 100 of this embodiment includes a housing frame 3, a support member 2, and at least one fan 1. The support member 2 is secured on the housing frame 3, and the support member 2 includes a conductive circuit 22 and at least one conductive area 212 (see FIG. 2) electrically connected to the conductive circuit 22.

In this embodiment, the conductive circuit 22 is configured to connect with a power supply (not shown). In this embodiment, the support member 2 is, for example, a rigid circuit board. In other embodiments, the support member 2 may also include an insulation board, and a circuit, a cable, or a flexible circuit board disposed on the insulation board. Therefore, the support member 2 has the functions of supporting and carrying the circuit.

As shown in FIG. 3, each fan 1 includes a securing structure 15, a hub 101 that rotates relative to the securing structure 15, and a plurality of blades 11 extending from the hub 101. The securing structure 15 of each fan 1 is secured on the support member 2, and the securing structure 15 includes a conductive portion 131 that makes conductive contact with the corresponding conductive area 212 (see FIG. 2).

In this embodiment, the at least one fan 1 includes a plurality of fans 1. The at least one conductive area 212 includes a plurality of conductive areas 212. The housing frame 3 includes a plurality of setting areas 31 for accommodating the fans 1. The support member 2 is strip-shaped and continuously passes through the plurality of setting areas 31, so that the conductive areas 212 of the support member 2 respectively correspond to the setting areas 31. Therefore, when the fans 1 are disposed in the setting areas 31 of the housing frame 3, the fans 1 will be in conduction with the support member 2 and electrically connected to the conductive circuit 22. Of course, in other embodiments, the form of the support member 2 is not limited thereto. In other embodiments, the support member 2 may not be in the form of a single strip, but composed of a combination of multiple line segments, with each segment passing through the corresponding setting area 31 and connected outside the setting area 31.

The heat dissipation device 100 of this embodiment utilizes the conductive portion 131 of the fan 1 to be in conductive contact with the conductive area 212 of the support member 2, achieving power supply to the fan 1. Such a design facilitates the assembly and disassembly of the fan 1 in a simpler and more convenient manner, replacing the conventional method where each fan is individually connected to the power supply via wiring. The design not only ensures that the heat dissipating device 100 maintains a neat appearance but also reduces the risk of short circuits. The advantages become particularly evident when multiple fans 1 are employed, as the absence of cable connections allows for quicker assembly and disassembly of any single fan 1. This design meets the requirement that all users be able to replace the fan 1 independently.

In addition, since the fans 1 of the heat dissipation device 100 are connected to the power supply only through one set of the conductive circuit 22. The conductive circuit 22 is, for example, a flat flexible cable or a wire. As shown in FIG. 1, in this embodiment, the housing frame 3 includes a single cable management structure 4 for securing the conductive circuit 22. The housing frame 3 does not need to be provided with multiple cable management structures 4, resulting in a simpler structure. The housing frame 3 is also easier to manufacture (e.g., during injection molding process and demolding process). Of course, in other embodiments, the conductive circuit 22 may also be a circuit on the support member 2, and electrically connected to the outside via springs or other structures.

It is worth mentioning that, as shown in FIG. 4, in this embodiment, the securing structure 15 of each fan 1 includes a locking portion 125, and the support member 2 includes an engaging slot 211 that correspondingly engages with the locking portion 125. Through the engagement of the locking portion 125 with the support member 2, rapid assembly and disassembly of the fan 1 and the support member 2 may be realized.

In this embodiment, the locking portion 125 includes at least two elastic engaging arms 126 distributed in a symmetrical manner. Each elastic engaging arm 126 includes a protrusion 126A located at an end portion. The protrusion 126A passes through the engaging slot 211 and reversely engages with the support member 2. Specifically, in this embodiment, the locking portion 125 includes four elastic engaging arms 126 distributed symmetrically around the circumference. Through the symmetrical distribution of the four elastic engaging arms 126 engaging with the engaging slot 211, circumferential engagement in four directions may be achieved, thus ensuring stability after engagement.

In addition, in this embodiment, the support member 2 has a strip shape, and the support member 2 is provided with multiple annular plate portions (mounting portions 21) that may dock with the securing structures 15. The engaging slot 211 is located at the center of the annular plate portion. By using the strip-shaped support member 2 to connect the fans 1 in series, it is possible to realize independent assembly and disassembly of the fans 1. That is to say, the heat dissipation device 100 may ensure the stability of the configuration of the fans 1 through the annular plate portions (mounting portions 21), and may also facilitate positioning between the fans 1 and the support member 2.

In addition, in this embodiment, the strip-shaped support member 2 has a smaller dimension compared to conventional plastic brackets, enabling reduction of wind resistance and improvement of heat dissipation efficiency. In this embodiment, the support member 2 is integrally formed, but in other embodiments, the support member 2 may also be formed by combining and assembling multiple components.

Furthermore, as shown in FIG. 6, in this embodiment, because the support member 2 is located on the securing structure 15, and the securing structure 15 has an elevating function, the support member 2 may be positioned further away from a panel of the housing frame 3 compared to the housing frame 3, and may provide more space for the blades 11 with a greater height H to be set, without interfering with the blades 11 at a higher level.

In this embodiment, the height H (see FIG. 6) of the blades 11 is greater than 9 millimeters. Compared to general blades 11 with a height of 8 millimeters, the blades 11 of the present disclosure may effectively improve the airflow. In this embodiment, the height H of the blades 11 may be up to 10.75 millimeters. Even when the thickness of the heat dissipation device 100 is subject to spatial limitations, the height H of the blades 11 may be effectively increased to enhance airflow, thereby improving heat dissipation efficiency.

On the other hand, as shown in FIG. 3, in this embodiment, the housing frame 3 includes a plurality of mounting studs 32 located at the periphery of the setting areas 31. The support member 2 includes a plurality of mounting holes 23 corresponding to the mounting studs 32. The support member 2 is secured on the housing frame 3 through a plurality of screws, which pass through the mounting holes 23 and are secured on the mounting studs 32.

In addition, as shown in FIG. 5, in this embodiment, the securing structure 15 of each fan 1 includes a connection plate 12 and a driver 13. The driver 13 is located within the accommodating chamber 10 of the hub 101. The connection plate 12 covers the accommodating chamber 10. The driver 13 is disposed on the connection plate 12 and cooperatively secures a micro motor. The micro motor is configured to drive the blades 11 to rotate.

The connection plate 12 is provided with elastic locking portions 125 to engage with the support member 2, thereby enabling quick assembly and disassembly of the fan 1 and the support member 2. The conductive portion 131 is located on the driver 13. The connection plate 12 includes a docking hole 122 for the conductive portion 131 to pass through. The conductive portion 131 passes through the docking hole 122 to contact the corresponding conductive area 212, thereby achieving the effect of electrical connection. The fan 1 does not require additional cables for connection, making assembly and disassembly more convenient and significantly improving production and maintenance efficiency.

In this embodiment, the connection plate 12 includes a first bump 123 and a second bump 124. The support member 2 (see FIG. 4) is disposed between the first bump 123 and the second bump 124 to be limited. The heat dissipation device 100 achieves precise positioning of the support member 2 through the first bump 123 and the second bump 124 being located on both sides of the support member 2, ensuring that the connection plate 12 and the support member 2 cannot rotate relative to each other after engagement, and enabling convenient engagement of the fan 1 and the support member 2, ensuring that the conductive portion 131 can be in precise conductive contact with the conductive area 212 of the support member 2.

The following illustrates heat dissipation devices 100a and 100b of other embodiments. Components that are the same or similar to the previous embodiment are represented by the same or similar reference numerals. Only the main differences will be illustrated, and the same or similar aspects will not be elaborated upon.

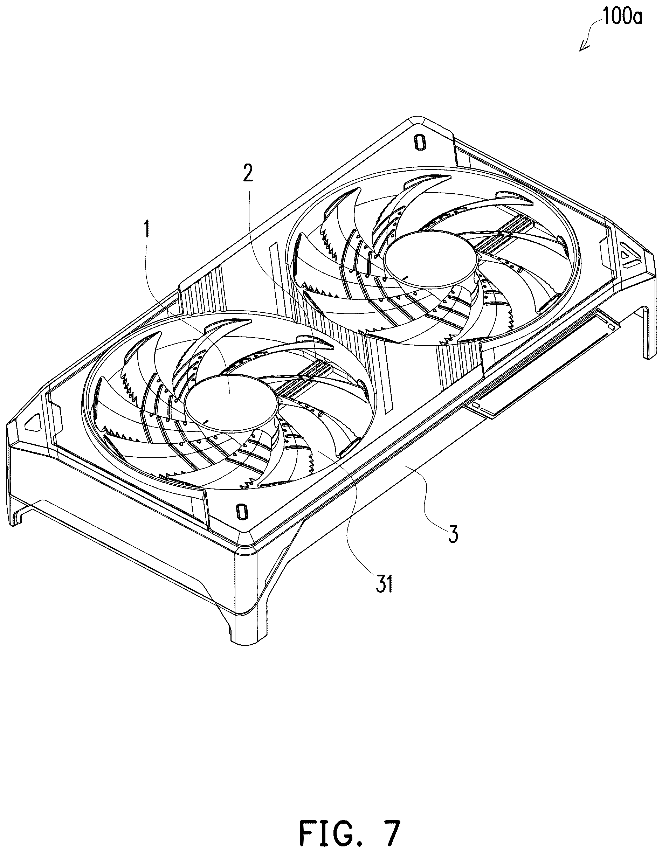

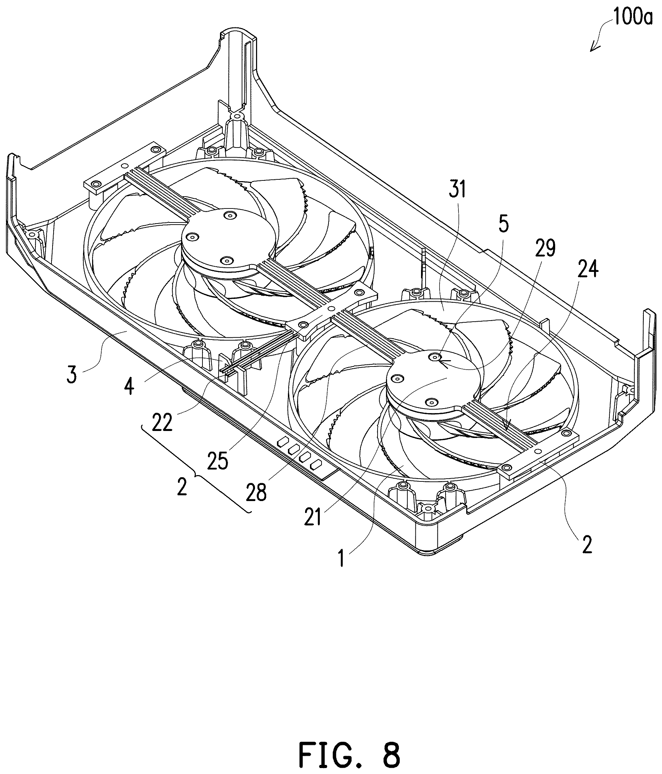

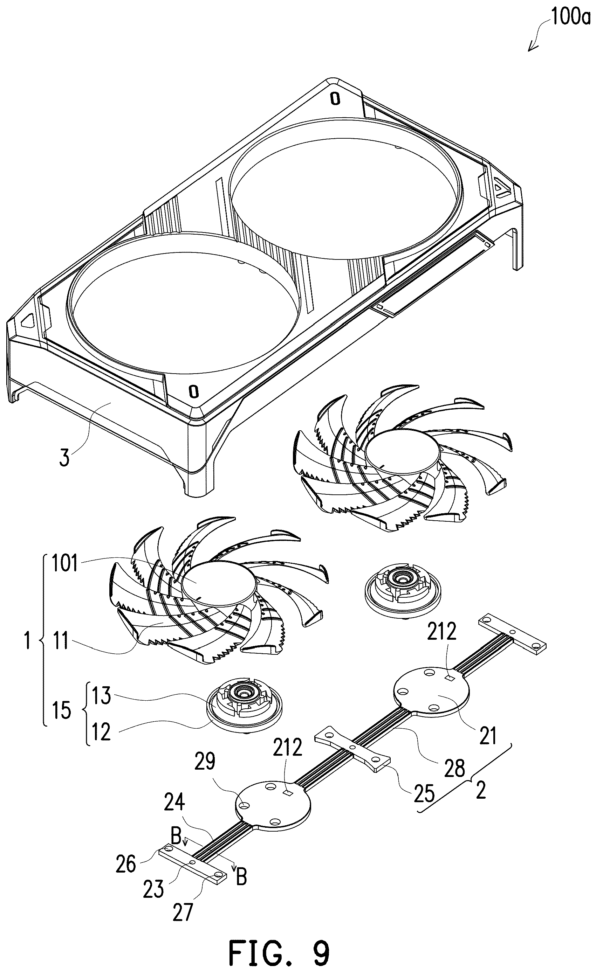

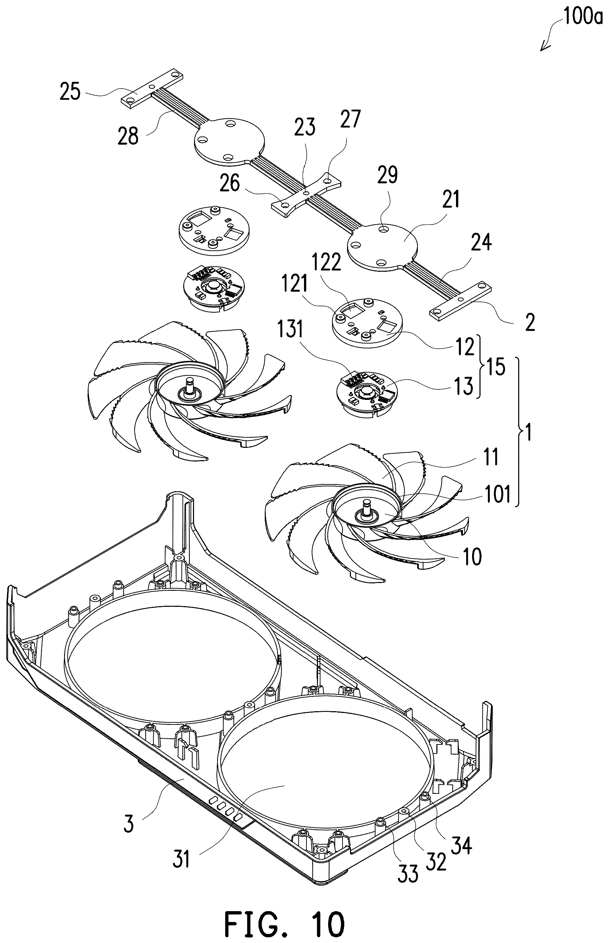

FIG. 7 and FIG. 8 are schematic views of different perspectives of a heat dissipation device according to another embodiment of the present disclosure. FIG. 9 and FIG. 10 are exploded schematic views of FIG. 7 and FIG. 8.

Please refer to FIG. 7 to FIG. 10, the main difference between the heat dissipation device 100a of FIG. 8 and the heat dissipation device 100 of FIG. 1 lies in that, in this embodiment, the support member 2 includes at least one perforated hole 24 (see FIG. 8) corresponding to the at least one fan 1 and passing through the support member 2. The heat dissipation device 100a may improve air circulation by setting perforated holes 24 on the support member 2, which not only saves material and reduces weight, but also reduces wind resistance and increases airflow.

In this embodiment, the at least one perforated hole 24 includes a plurality of perforated holes 24, the perforated holes 24 are elongated. In other embodiments, the perforated holes 24 may also be circular. In addition, in this embodiment, the perforated holes 24 are located in the interior of the support member 2. In other embodiments, the perforated holes 24 may also be located at the edge of the support member 2, in the form of being partially open and recessed towards the edge. The form of the perforated holes 24 is not limited thereto.

As shown in FIG. 8, in this embodiment, the support member 2 includes at least one mounting portion 21, a plurality of mounting fixing blocks 25, and a plurality of connection portions 28 disposed between the at least one mounting portion 21 and the mounting fixing blocks 25. The positions of the connection portions 28 correspond to the blades 11. In this embodiment, each of the connection portions 28 includes the perforated hole 24.

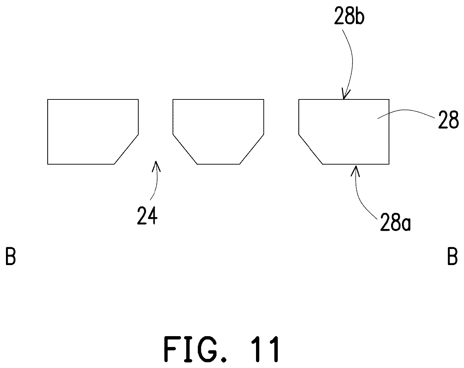

FIG. 11 is a cross-sectional view taken along line B-B of FIG. 9. Please refer to FIG. 11, in this embodiment, the support member 2 includes a first surface 28a away from the fan 1 and a second surface 28b close to the fan 1. Each of the perforated holes 24 has a dimension at the first surface 28a that is greater than or equal to the dimension at the second surface 28b. Such design allows the airflow to be more concentrated when expelled by the fan after passing through the perforated holes 24.

In an embodiment, the inner wall of the perforated holes 24 may also have rounded corners. In an embodiment, the inner wall of the perforated holes 24 may also be trumpet-shaped. In an embodiment, the dimension of the perforated holes 24 may also first decrease and then expand in a direction from the first surface 28a to the second surface 28b. The form of the perforated holes 24 is not limited thereto.

Please return to FIG. 9, each of the conductive areas 212 is located at the corresponding mounting portion 21, and each of the mounting portions 21 corresponds to the securing structure 15 of the corresponding fan 1. In this embodiment, the number of the mounting portions 21 and the number of the conductive areas 212 both correspond to the number of the fans 1.

In addition, as shown in FIG. 10, in this embodiment, the securing structure 15 of each fan 1 includes a screw set 121. The support member 2 includes a hole 29 corresponding to the screw set 121. Each fan 1 is secured on the support member 2 through a fastener 5 (see FIG. 8), which passes through the hole 29 and is secured on the screw set 121. Therefore, when the securing structure 15 of each fan 1 is secured on the support member 2, the conductive portion 131 of the fan 1 is in conductive contact with the conductive area 212 of the support member 2.

In addition, the mounting fixing blocks 25 are secured on the housing frame 3. In this embodiment, the housing frame 3 further includes a plurality of sets of positioning columns corresponding to the mounting studs 32. Each of the plurality of sets of positioning columns includes a first positioning column 33 and a second positioning column 34, disposed on opposite sides of the corresponding mounting stud 32. The mounting fixing blocks 25 of the support member 2 extend along a direction perpendicular to an extending direction of the support member 2. The mounting fixing block 25 and the connection portion 28 intersect in a cross shape or T shape. Both ends of each of the mounting fixing blocks 25 include a first positioning hole 26 and a second positioning hole 27 corresponding to the first positioning column 33 and the second positioning column 34 respectively. Therefore, the support member 2 may be aligned more stably with the housing frame 3.

In this embodiment, the mounting portion 21 of the support member 2 is connected to the mounting fixing block 25 and the connection portion 28 by any one or two or more of, but not limited to, integral molding, clips, screws, and fusion.

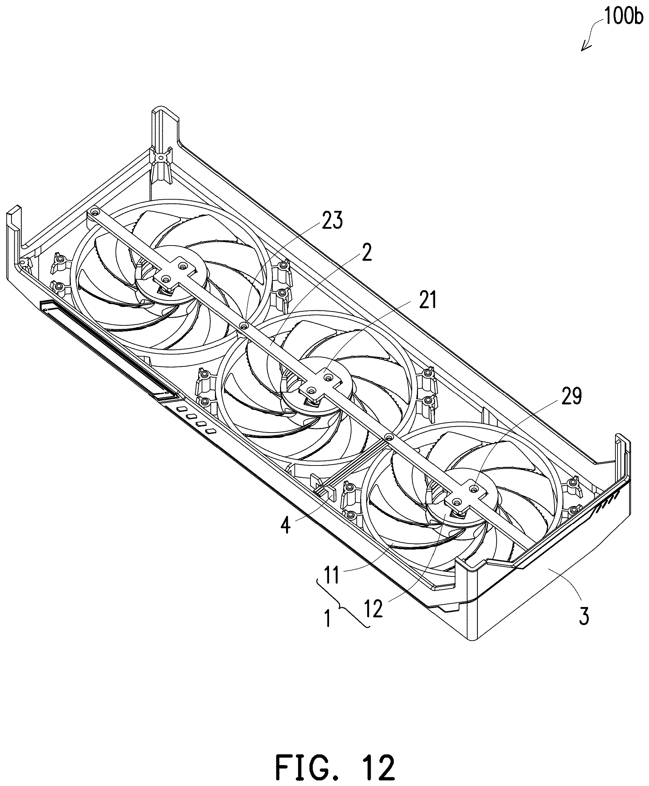

FIG. 12 is a schematic view of different perspectives of a heat dissipation device according to another embodiment of the present disclosure. The main difference between the heat dissipation device 100b of FIG. 12 and the heat dissipation device 100 of FIG. 1 lies in that, in this embodiment, the fan 1 is secured on the support member 2 by fastening. Similarly, the heat dissipation device 100b utilizes the conductive contact between the conductive portion 131 of the fan 1 and the conductive area 212 of the support member 2 to achieve power supply to the fan 1, thereby making the assembly and disassembly of the fan 1 simpler and more convenient.

The fan of the heat dissipation device of the present disclosure is secured on the support member through the securing structure, and the support member is secured on the housing frame, which is simple in structure. In addition, the heat dissipation device of the present disclosure utilizes the conductive contact between the conductive portion of the fan and the conductive area of the support member to achieve power supply to the fan. Such mounting structure enables the assembly and disassembly of the fan to be simpler and more convenient, without requiring additional cables for connection, making assembly and disassembly more convenient, and significantly improving production efficiency. The advantages are more evident especially when multiple fans are employed, as the connection without cables enables faster assembly and disassembly of one of the fans, meeting the requirement that all users may replace the fan by themselves.

## Claims

1. A heat dissipation device (100, 100a, 100b), **characterized in** comprising:
a housing frame (3);
a support member (2), secured on the housing frame (3) and comprising a conductive circuit (22) and at least one conductive area (212) electrically connected to the conductive circuit (22); and
at least one fan (1), each of the at least one fan (1) comprising a securing structure (15), a hub (101) rotating relative to the securing structure (15), and a plurality of blades (11) extending from the hub (101), the securing structure (15) of each of the at least one fan (1) being secured on the support member (2), the securing structure (15) comprising a conductive portion (131) in conductive contact with the corresponding conductive area (212).

2. The heat dissipation device (100, 100a, 100b) according to claim 1, **characterized in that** the securing structure (15) of each of the at least one fan (1) comprises a locking portion (125), and the support member (2) comprises an engaging slot (211) correspondingly engaged with the locking portion (125).

3. The heat dissipation device (100, 100a, 100b) according to claim 2, **characterized in that** the locking portion (125) comprises at least two elastic engaging arms (126) distributed symmetrically, each of the elastic engaging arms (126) comprises a protrusion (126A) located at an end portion, the protrusion (126A) passes through the engaging slot (211) and reversely engages with the support member (2).

4. The heat dissipation device (100, 100a, 100b) according to claim 1, **characterized in that** the securing structure (15) of each of the at least one fan (1) comprises a screw set (121), the support member (2) comprises a hole (29) corresponding to the screw set (121), and each of the at least one fan (1) is secured on the support member (2) by a fastener, which passes through the hole (29) and is secured on the screw set (121).

5. The heat dissipation device (100, 100a, 100b) according to any one of claims 1-4, **characterized in that** the support member (2) comprises at least one perforated hole (24) corresponding to the at least one fan (1) and passing through the support member (2).

6. The heat dissipation device (100, 100a, 100b) according to claim 5, **characterized in that** the support member (2) comprises a first surface (28a) away from the at least one fan (1) and a second surface (28b) close to the at least one fan (1), and each of the at least one perforated hole (24) has a dimension at the first surface (28a) greater than or equal to a dimension at the second surface (28b).

7. The heat dissipation device (100, 100a, 100b) according to any one of claims 1-6, **characterized in that** the at least one fan (1) comprises a plurality of fans (1), the at least one conductive area (212) comprises a plurality of conductive areas (212), the housing frame (3) comprises a plurality of setting areas (31) accommodating the plurality of fans (1), the support member (2) continuously passes through the plurality of setting areas (31), and the plurality of conductive areas (212) respectively correspond to the plurality of setting areas (31).

8. The heat dissipation device (100, 100a, 100b) according to claim 7, **characterized in that** the housing frame (3) comprises a plurality of mounting studs (32) located at peripheries of the plurality of setting areas (31), the support member (2) comprises a plurality of mounting holes (23) corresponding to the plurality of mounting studs (32), and the support member (2) is secured on the housing frame (3) by a plurality of screws, which pass through the mounting holes (23) and are secured on the plurality of mounting studs (32).

9. The heat dissipation device (100, 100a, 100b) according to claim 8, **characterized in that** the housing frame (3) comprises a plurality of sets of positioning columns corresponding to the plurality of mounting studs (32), each of the plurality of sets of positioning columns comprises a first positioning column (33) and a second positioning column (34) disposed on opposite sides of the corresponding mounting stud (32), the support member (2) comprises a plurality of mounting fixing blocks (25) extending along a direction perpendicular to an extending direction of the support member (2), and both ends of each of the plurality of mounting fixing blocks (25) comprise a first positioning hole (26) and a second positioning hole (27) respectively corresponding to the first positioning column (33) and the second positioning column (34).

10. The heat dissipation device (100, 100a, 100b) according to any one of claims 1-9, **characterized in that** the securing structure (15) of each of the at least one fan (1) comprises a connection plate (12) and a driver (13), the driver (13) is located in an accommodation chamber of the hub (101), the connection plate (12) covers the accommodation chamber, the securing structure (15) of each of the at least one fan (1) is connected to the support member (2) through the connection plate (12), the conductive portion (131) is located on the driver (13), the connection plate (12) comprises a docking hole (122) for the conductive portion (131) to pass through, and the conductive portion (131) passes through the docking hole (122) to contact the corresponding conductive area (212).

11. The heat dissipation device (100, 100a, 100b) according to claim 10, **characterized in that** the connection plate (12) comprises a first bump (123) and a second bump (124), and the support member (2) is disposed between the first bump (123) and the second bump (124) to be limited.

12. The heat dissipation device (100, 100a, 100b) according to any one of claims 1-11, **characterized in that** the support member (2) comprises a circuit board, or the support member (2) comprises an insulation board, and a circuit, a cable, or a flexible circuit board disposed on the insulation board.

13. The heat dissipation device (100, 100a, 100b) according to any one of claims 1-12, **characterized in that** the support member (2) comprises at least one mounting portion (21), a plurality of mounting fixing blocks (25), and a plurality of connection portions (28) disposed between the at least one mounting portion (21) and the plurality of mounting fixing blocks (25), each of the mounting portions (21) corresponds to the securing structure (15), the at least one conductive area (212) is located at the at least one mounting portion (21), the plurality of mounting fixing blocks (25) are secured on the housing frame (3), and each of the plurality of connection portions (28) comprises a perforated hole (24).

14. The heat dissipation device (100, 100a, 100b) according to claim 13, **characterized in that** the plurality of connection portions (28), the at least one mounting portion (21), and the plurality of mounting fixing blocks (25) have equal heights, and a height of the plurality of blades (11) is greater than 9 millimeters.

15. The heat dissipation device (100, 100a, 100b) according to any one of claims 1-14, **characterized in that** the housing frame (3) comprises a single cable management structure (4) configured to secure the conductive circuit (22).
